Europäisches Patentamt

(19) European Patent Office

Office européen des brevets

(11) Publication number: **0 157 505 B1**

(12) **EUROPEAN PATENT SPECIFICATION**

(45) Date of publication of patent specification: **09.10.91**  (51) Int. Cl.⁵: **H01L 23/66, H01L 23/06**

(21) Application number: **85301547.7**

(22) Date of filing: **06.03.85**

(54) **High-frequency semiconductor device.**

(30) Priority: **06.03.84 JP 42605/84**

(43) Date of publication of application:
**09.10.85 Bulletin 85/41**

(45) Publication of the grant of the patent:
**09.10.91 Bulletin 91/41**

(84) Designated Contracting States:
**DE FR GB IT SE**

(56) References cited:
**EP-A- 0 110 997**

**PATENT ABSTRACTS OF JAPAN, vol. 5, no.
95 (E-62)[767], 20th June 1981; & JP-A-56
40263**

**IEEE TRANSACTIONS ON MICROWAVE THE-
ORY AND TECHNIQUES, vol. MTT-29, no. 4,
April 1981, pages 314-322, New York, US; J.
VAN BLADEL: "Dielectric resonator in a
waveguide below cutoff"**

(73) Proprietor: **FUJITSU LIMITED
1015, Kamikodanaka Nakahara-ku
Kawasaki-shi Kanagawa 211(JP)**

(72) Inventor: **Yamamura, Shigeyuki
5-22-14, Kamiyabe
Sagamihara-shi Kanagawa 229(JP)**

(74) Representative: **Fane, Christopher Robin King
et al
HASELTINE LAKE & CO. Hazlitt House 28
Southampton Buildings Chancery Lane
London, WC2A 1AT(GB)**

## Description

The present invention relates to semiconductor devices and more particularly to an improvement in a container for housing a high-frequency semiconductor circuit operating at a radio-frequency such as a microwave or millimetre wave frequency.

A previously proposed semiconductor device having a microwave circuit housed within a ceramic container suffers from degradation of circuit characteristics due to the frequency resonance of the container and from damage of the container due to the difference between the thermal expansion coefficients of the ceramic and a metal base plate.

There is discussed in WO 83/03922 (corresponding to EP-A-0 110 997) a semiconductor device wherein the container is substantially wholly made of metal, but is penetrated by ceramic portions through which electrical connections are made to the inner circuit. The semiconductor device concerned comprises a metallic container having an interior base surface bounded by mutually-opposed first and second side walls of the container that are spaced apart in a first direction and by mutually-opposed third and fourth side walls that are spaced apart in a second direction, perpendicular to the said first direction. The device also comprises a radio frequency semiconductor circuit mounted on the said interior base surface and operable at a predetermined signal frequency, and electrically-conductive cover means carried by the container walls, at a distance from the said interior base surface that is less than the distance between the said first and second walls, so as to complete the enclosure of the circuit in the container. Input and output terminals are connected to the said circuit and extend respectively through (and are electrically isolated from) the said third and fourth side walls so as to be accessible from outside the container.

However, with this structure, radio waves may propagate from the input side to the output side within the container space, causing undesired characteristics such as noise in the output signal, if the impedance of a part of the circuit matches the impedance of the space within the container, which impedance is usually very high. Any such matching can permit radiation of the microwave from the input side within the container, resulting in so-called rectangular waveguide mode signal propagation within the container. Therefore, undesirable wave propagation can occur at a frequency which is used in the circuit of the container.

Japanese Patent Publication JP-A-56-40263 discloses a similarly-packaged semiconductor device, in which susceptibility to undesirable oscillation is reduced by including within the container (package) a metallised wall portion, formed integrally with the cover means (cap) and projecting downwardly therefrom directly above the semiconductor circuit element. Being intermediately located between and parallel to the opposed walls carrying respectively the input and output terminals, the projecting wall portion serves to inhibit propagation of radio waves between those opposed walls. The metallised wall portion concerned, however, is located centrally with respect to the container and accordingly restricts useful space therein.

Alternatively, in order to avoid undesirable wave propagation from the input side to the output side within the container space, the high-pass filter constituted by the waveguide formed by the container should have a cutoff frequency higher than the frequency of the signal used in the circuit. An increase in such cut-off frequency can be achieved in general by reducing the length of the longer side of the rectangular waveguide section of the container's inner space. However, this may conflict with a requirement for supplementary space in the container, for handling parts of the microwave circuit, in addition to and adjacent to the space for mounting the microwave circuit on the container bottom surface. Such supplementary space may also be utilised for mounting parts of, for instance, a DC bias circuit of the microcircuit.

According to the present invention, there is provided a semiconductor device comprising:

a metallic container having an interior base surface bounded by mutually-opposed first and second side walls of the container that are spaced apart in a first direction and by mutually-opposed third and fourth side walls that are spaced apart in a second direction, perpendicular to the said first direction;

a radio frequency semiconductor circuit mounted on the said interior base surface and operable at a predetermined signal frequency;

electrically-conductive cover mean disposed on the said container side walls, at a distance from the said interior base surface that is less than the distance between the said first and second walls, so as to complete the enclosure of the circuit in the container; and

input and output terminals connected to the said circuit and extending respectively through and being electrically isolated from the said third and fourth side walls so as to be accessible from outside the container;

characterised in that the said container includes an electrically-conductive projection extending, from the cover means to the said interior base surface, between the said first side wall and the said circuit whilst leaving sufficient supplementary space in the container between the said circuit and the said first side wall for mounting supplementary circuit elements or for handling elements of the said circuit during mounting thereof, the said projection serving to reduce the effective inner width of the container, measured in the said first direction, whereby the high-pass cut-off frequency for waveguide mode propagation through the container in the said second direction is raised above the said predetermined signal frequency.

The said radio frequency circuitry may comprise, for example, a microwave amplifier or oscillatory circuit.

Reference will now be made, by way of example, to the accompanying drawings, in which:-

Figure 1 is a perspective view of part of a semiconductor device embodying the present invention;

Figure 2(A) is a plan view of the part shown in Figure 1;

Figure 2(B) is a sectional view corresponding to the line I-I of Figure 2(A);

Figures 3(A) and 3(B) are illustrations, corresponding to Figures 2(A) and 2(B), of another device embodying the invention;

Figures 4(A) and 4(B) are illustrations, corresponding to Figures 2(A) and 2(B), of yet another device embodying the invention;

Figure 5 shows respective plan views of parts of further devices embodying the present invention; and

Figure 6 shows a schematic plan view of a combination of semiconductor devices embodying the present invention.

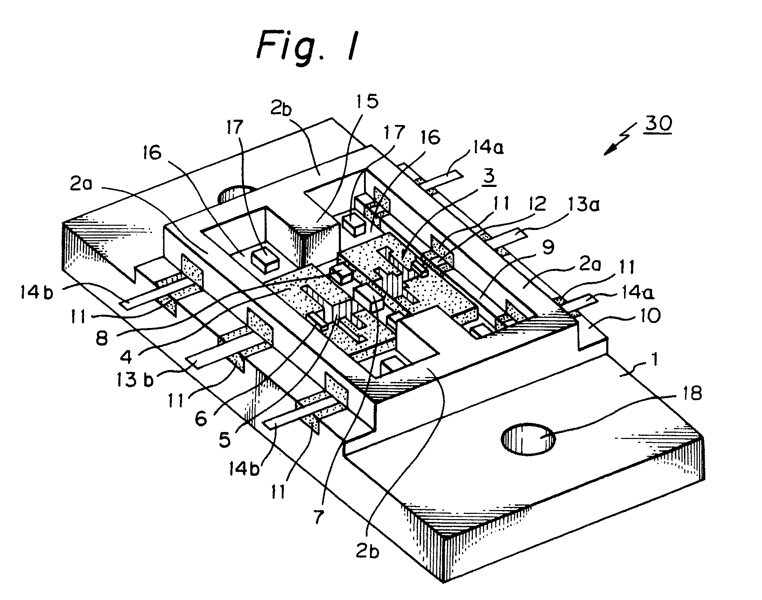

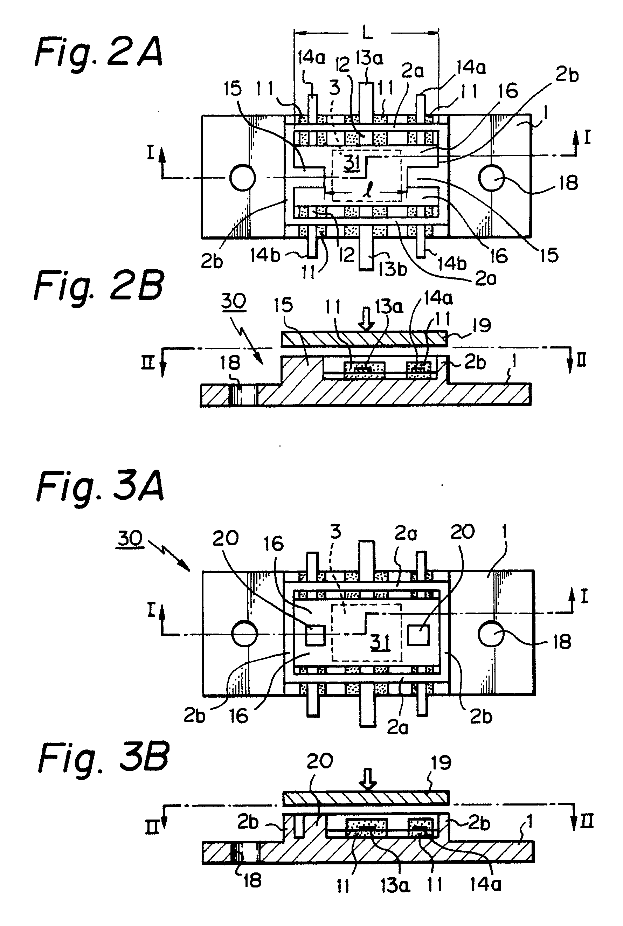

A first embodiment of the present invention is illustrated in Figs. 1 and 2. A metallic container 30 containing a microwave circuit 3 therein includes a metallic base plate 1 and side walls 2a and 2b forming an essentially rectangular shape on the base plate 1 and accommodating the microwave circuit 3 therein. A cap 19 (Fig. 2(B)) is disposed on the side walls 2a, 2b for covering the container 30. The container 30 is made of metal or ceramic having a metallized surface. A hole 18 for attaching the container 30 to another location is provided on the base plate 1.

The microwave circuit 3 is a strip line type circuit and includes, for example, a pair of ceramic plates 4, on which a matching circuit pattern 5 is printed and a DC blocking capacitor 6 is mounted, and a field effect transistor (FET) 7 and capacitors 8 disposed between the ceramic plates 4, to constitute a single end type amplifier. The parts are connected to each other by wires (not shown).

Capacitors 17, which constitute a supplementary bias circuit for DC power supply or ground connection, are mounted beside the microwave circuit 3 and connected thereto by wires (not shown). Therefore, the bottom surface within the side walls 2a, 2b of the container 30 should provide not only space 31 (Fig. 2) for mounting the microwave circuit 3 but also supplementary space 16 for mounting electric components for a supplementary circuit such as a bias circuit. Such supplementary space 16 is also required as space for handling elements of the microwave circuit 3 when mounting it on the bottom surface of the container 30.

Three terminals 12 are disposed on one side of the side wall 2a and three other terminals are disposed on the opposite side of the side wall 2a. Each terminal 12 penetrates through the side wall 2a so as to interconnect the inner circuits and outer lines (not shown). Each terminal 12 is surrounded by ceramic 11 so as to be isolated electrically from the side wall 2a. The size of the ceramic 11 is determined with a view to matching the impedance of the terminal concerned to the impedance of the inner circuit. Steps 9, 10 having a thickness corresponding to the thickness of the ceramic plate 4 are formed on the inner and outer sides of the side wall 2a. Each terminal 12 is exposed on the ceramic 11 on the steps 9 and 10.

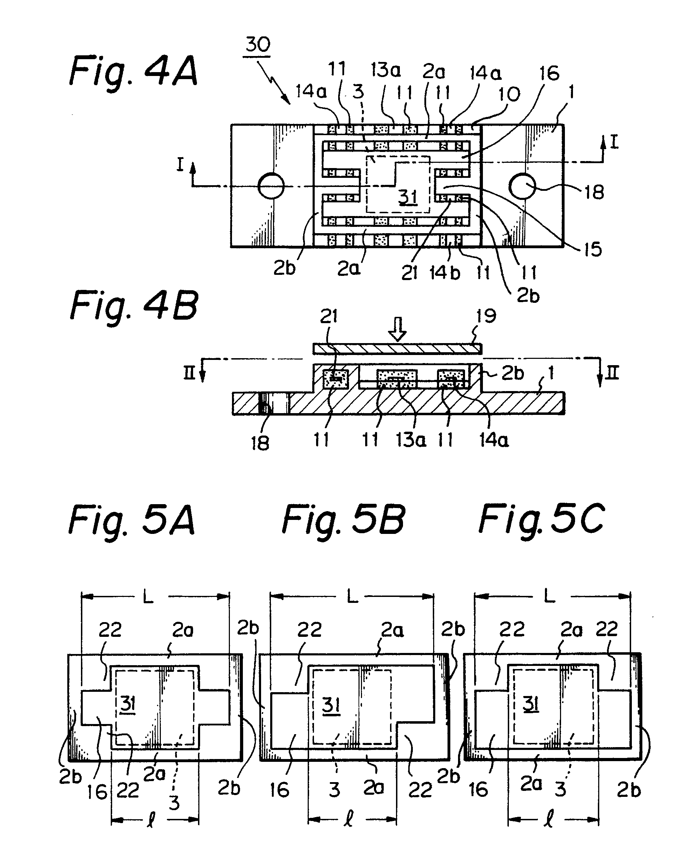

Leads 13a, 13b, 14a, 14b, each of which is integral with or connected to a terminal 12, project out of the side wall 2a. Leads 13a and 13b designate a radio frequency wave input lead and output lead, respectively. Metallized film may be formed on the ceramic 11 from the inner step 9 to the outer step 10 penetrating the side wall 2a to constitute a terminal 12. With such a structure, the outer projecting leads 13a, 13b, 14a, 14b may be deleted, as illustrated in Fig. 4(A). If a radio frequency wave circuit using a self-bias FET or a diode is housed in the container, the number of the DC terminals may be one each side.

A projection 15 is formed inward of and integral with each side wall 2b on each side perpendicular to the side wall 2a having the terminals 12. The projection 15 extends in height between the lower surface of the cap 19 and the bottom surface of container. The projection 15 functions as a filter of the radio wave propagation within the container in a waveguide mode.

The metal container 30 with its covering cap 19 functions as a rectangular waveguide, the properties of the waveguide being dependent upon the dimensions of the waveguide in the two directions perpendicular to the direction of propogation of the wave therein.

The waveguide functions as a high-pass filter, and the cutoff wavelength of the waveguide mode wave propagating within the container between the side walls 2a from the input terminal lead 13a to the output terminal lead 13b mainly depends on the effective length of the longer side of the rectangular waveguide section, that is to say on the width off the cross-section parallel to the side wall 2a.

That width is the distance $\ell$ between the projections 15, which is shorter than the length L between the side walls 2b that would otherwise determine the cutoff wavelength in the case where the projections 15 are not provided. Therefore, the cutoff wavelength is shortened by the presence of the projections 15, which means the high-pass cutoff frequency is increased. The relationship between the cutoff wavelength λ and the effective length of the longer side of the waveguide section $\ell$ (or L) is $\lambda = 2\ell$ (or 2 L).

Therefore, by arranging the length $\ell$ so that the cutoff frequency is higher than a predetermined operating signal frequency used in the microwave circuit, waveguide mode propagation of a wave having the said predetermined operating frequency does not occur. Accordingly, such wave propagation cannot cause any of the input high frequency signal introduced into the microwave circuit 3 to be transmitted directly from the input terminal lead 13a to the output terminal lead 13b. Therefore, noise due to such waveguide mode propagation, and transmission loss, are minimized and the circuit characteristics are stabilized. Also, the provision of an appropriately sized projection 15 can make it possible to use a very high frequency operating signal.

With the above arrangement, although the effective inner width of the container as a waveguide is shortened, supplementary space 16 still remains on both sides of the projection 15, so that the microwave circuit can be conveniently handled during fabrication of the device when that circuit is introduced onto the bottom surface of the container.

A second embodiment of the present invention is illustrated in Fig. 3. In this embodiment, metallic projections 20 which are separated from the side wall 2b are provided as cutoff means for filtering the waveguide mode propagation of the radio wave, instead of the projection 15 of the first embodiment. The other constructions, functions, and effects of the structure are substantially the same as those of the first embodiment. With this structure, the space between the projections 20 and the side wall 2b is also utilized as supplementary space.

A third embodiment is illustrated in Fig. 4. In this embodiment, the projection 15 arranged similarly to the structure of the first embodiment has an electric terminal 21 consisting of a metallic film, surrounded laterally by ceramic 11, penetrating through the projection. Also, the outer leads 13a, 13b, 14a, 14b do not project out of the container edge. The other constructions, functions, and effects are substantially the same as those of the first embodiment. With the structure of the third embodiment, the electric components disposed in the supplementary space 16 on the opposite sides of the projection 15 can be easily connected to each other by using the terminal 21 penetrating through the projection 15. Also, it is convenient to dispose a plurality of the containers side by side closely in parallel, since the leads are not projected out of the side wall of the container.

Further different formations of the container in accordance with the present invention are illustrated in Figs. 5(A), 5(B) and 5(C). In these examples, waveguide narrowing members 22 are formed on both sides of the space 31 for mounting a radio frequency semiconductor circuit such as a microwave circuit 3, leaving the supplementary space 16 as in the above-mentioned embodiments. The members 22 reduce the effective major width of the container from L to $\ell$, which width determines the cutoff frequency for the waveguide mode wave propagation.

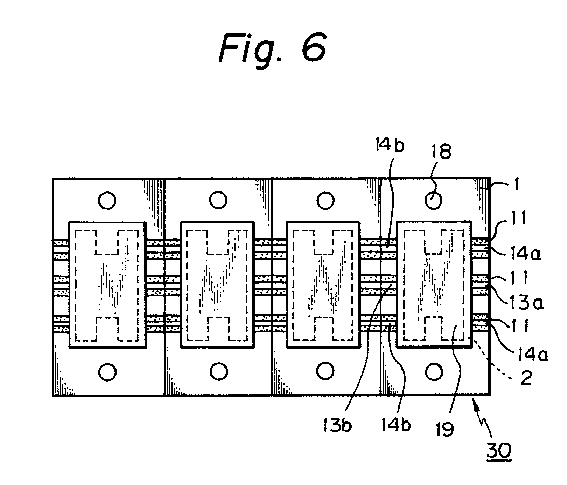

Figure 6 is an upper view of an arrangement of four semiconductor devices, each embodying the present invention, disposed close together side by side and connected to each other through the terminals 13a, 13b, 14a, 14b of each container 30. With such an arrangement, a plurality of semiconductor devices having stable characteristics and using a desired high frequency can be compactly interconnected.

## Claims

1. A semiconductor device comprising:

   a metallic container (30) having an interior base surface (1) bounded by mutually-opposed first and second side walls (2b) of the container (30) that are spaced apart in a first direction and by mutually-opposed third and fourth side walls (2a) that are spaced apart in a second direction, perpendicular to the said first direction;

   a radio frequency semiconductor circuit (3) mounted on the said interior base surface (1) and operable at a predetermined signal frequency;

   electrically-conductive cover means (19) disposed on the said container side walls (2a, 2b), at a distance from the said interior base surface (1) that is less than the distance between the said first and second walls (2b), so as to complete the enclosure of the circuit (3) in the container (30); and

   input and output terminals (13a, 13b) connected to the said circuit (3) and extending respectively through and being electrically isolated from the said third and fourth side walls (2a) so as to be accessible from outside the container (30);

   characterised in that the said container (30) includes an electrically-conductive projection (15/20/22) extending, from the cover means (19) to the said interior base surface (1), between the said first side wall (2b) and the said circuit (3) whilst leaving sufficient supplementary space (16) in the container (30) between the said circuit (3) and the said first side wall (2b) for mounting supplementary circuit elements or for handling elements of the said circuit (3) during mounting thereof, the said projection (15/20/22) serving to reduce the effective inner width of the container (30), measured in the said first direction, whereby the high-pass cut-off frequency for waveguide mode propagation through the container (30) in the said second direction is raised above the said predetermined signal frequency.

2. A device as claimed in claim 1, wherein supplementary circuitry (17) is mounted, within the container (30), in the said supplementary space (16).

3. A device as claimed in claim 1 or 2, wherein the said electrically-conductive projection (15/22) is integral with and projects from the said first side wall (2b) towards the said circuit (3).

4. A device as claimed in claim 1 or 2, wherein the said electrically-conductive projection (20) is separate from the said first side wall (2b).

5. A device as claimed in any preceding claim, including an electrical connection lead comprising an electric terminal (21), comprising a metallic film surrounded laterally by electrical insulation (11), which extends completely through the said electrically-conductive projection (15/20/22) in the said second direction.

6. A device as claimed in any preceding claim, mounted so that its said third side wall extends alongside the said fourth side wall of a further such device and having its said input terminal (13a) connected to the output terminal (13b) of the said further device.

7. A device as claimed in any preceding claim, wherein the container further includes a second electrically-conductive projection (15/20/22) extending, from the cover means (19) to the said interior base surface (1), between the said second side wall (2b) and the said circuit (3) whilst leaving sufficient supplementary space (16) in the container (30) between the said circuit (3) and the said second side wall (2b) for mounting further supplementary circuit elements or for handling elements of the said circuit (3) during mounting thereof.

## Revendications

1. Un dispositif à semiconducteurs comprenant :
   un boîtier métallique (30), ayant une surface de base intérieure (20) limitée par des première et seconde parois latérales (2b) du boîtier (30), qui sont mutuellement opposées et espacées dans une première direction, et par des troisième et quatrième parois latérales (2a) qui sont mutuellement opposées et espacées dans une seconde direction, perpendiculaire à la première direction;
   un circuit à semiconducteurs radiofréquence (3) monté sur la surface de base intérieure (1) et que l'on peut faire fonctionner à une fréquence de signal prédéterminée;
   une structure de couvercle conductrice de l'électricité (19) placée sur les parois latérales (2a, 2b) du boîtier, à une distance de la surface de base intérieure (1) qui est inférieure à la distance entre les première et seconde parois (2b), de façon à enfermer entièrement le circuit (3) dans le boîtier (30); et
   des bornes d'entrée et de sortie (13a, 13b) connectées au circuit (3) et traversant respectivement les troisième et quatrième parois latérales (2a), en étant électriquement isolées de celles-ci, de façon à être accessibles à l'extérieur du boîtier (30);
   caractérisé en ce que le boîtier (30) comprend un élément en saillie conducteur de l'électricité (15/20/22) qui s'étend à partir de la structure de couvercle (19) vers la surface de base intérieure (1), entre la première paroi latérale (2b) et le circuit (3), tout en laissant un espace supplémentaire suffisant (16) dans le boîtier (30) entre le circuit (3) et la première paroi latérale (2b), pour le montage d'éléments de circuit supplémentaires, ou pour la manipulation d'éléments du circuit (3) pendant le montage de ce dernier, cet élément en saillie (15/20/22) ayant pour fonction de réduire la largeur intérieure effective du boîtier (30), mesurée dans la première direction, grâce à quoi la fréquence de coupure passehaut pour la propagation en mode de guide d'ondes dans le boîtier (30), dans la seconde direction précitée, est augmentée jusqu'à une valeur supérieure à la fréquence de signal prédéterminée.

2. Un dispositif selon la revendication 1, dans lequel un circuit supplémentaire (17) est monté dans l'espace supplémentaire (16), à l'intérieur du boîtier (30).

3. Un dispositif selon la revendication 1 ou 2, dans lequel l'élément en saillie conducteur de l'électricité (15/22) est formé en une seule pièce avec la première paroi latérale (2b), et il fait saillie à partir de cette première paroi latérale vers le circuit (3).

4. Un dispositif selon la revendication 1 ou 2, dans lequel l'élément en saillie conducteur de l'électricité (20) est séparé de la première paroi latérale (2b).

5. Un dispositif selon l'une quelconque des revendications précédentes, comprenant un conducteur de connexion électrique qui comporte une borne électrique (21), comprenant une pellicule métallique entourée latéralement par un isolant électrique (11), qui traverse complètement l'élément en saillie conducteur de l'électricité (15/20/22) dans la seconde direction.

6. Un dispositif selon l'une quelconque des revendications précédentes, monté de façon que sa troisième paroi latérale s'étende le long de la quatrième paroi latérale d'un dispositif supplémentaire du même type, et dont la première borne d'entrée (13a) est connectée à la borne de sortie (13b) du dispositif supplémentaire.

7. Un dispositif selon l'une quelconque des revendications précédentes, dans lequel le boîtier comprend en outre un second élément en saillie conducteur de l'électricité (15/20/22) qui s'étend à partir de la structure de couvercle (19) vers la surface de base intérieure (1), entre la seconde paroi latérale (2b) et le circuit (3), tout en laissant un espace supplémentaire suffisante (16) dans le boîtier (30), entre le circuit (3) et la seconde paroi latérale (2b), pour le montage d'éléments de circuit supplémentaires, ou pour la manipulation d'éléments du circuit (3) pendant leur montage.

**Patentansprüche**

1. Halbleitervorrichtung mit:
einem metallischen Behälter (30), der eine innere Basisoberfläche (1) hat, die durch einander gegenüberliegende erste und zweite Seitenwände (2b) des Behälters (30), die in einer ersten Richtung mit Abstand voneinander angeordnet sind, und durch einander gegenüberliegende dritte und vierte Seitenwände (2a), die mit Abstand voneinander in einer zweiten Richtung, senkrecht zu der genannten ersten Richtung, angeordnet sind, begrenzt ist;
einer Radiofrequenz-Halbleiterschaltung (3), die auf der genannten inneren Basisoberfläche (1) montiert ist und mit einer vorbestimmten Signalfrequenz betreibbar ist;
einer elektrisch leitenden Abdeckeinrichtung (19), die an den genannten Behälterseitenwänden (2a, 2b) angeordnet ist, in einem Abstand von der genannten inneren Basisoberfläche 1, der kleiner als der Abstand zwischen den genannten ersten und zweiten Wänden (2b) ist, um so den Einschluß der Schaltung (3) in dem Behälter (30) zu vervollständigen;
Eingangs- und Ausgangsanschlüssen (13a, 13b), die mit der genannten Schaltung (3) verbunden sind und sich jeweils durch die genannten dritten und vierten Seitenwände (2a) erstrecken und elektrisch von ihnen isoliert sind, so daß sie von der Außenseite des Behälters (30) zugänglich sind;
dadurch gekennzeichnet, daß der genannte Behälter (30) einen elektrisch leitenden Vorsprung (15/20/22) enthält, der sich von der Abdeckeinrichtung (19) zu der genannten inneren Basisoberfläche (1) erstreckt, zwischen der genannten ersten Seitenwand (2b) und der genannten Schaltung (3), wobei ein hinreichender zusätzlicher Raum (16) in dem Behälter (30) zwischen der genannten Schaltung (3) und der genannten ersten Seitenwand (2b), gelassen wird, um zusätzliche Schaltungselemente aufzunehmen oder zur Handhabung von Elementen der genannten Schaltung (3) während der Montage, wobei der genannte Vorsprung (15/20/22) zur Reduzierung der effektiven inneren Breite des Behälters (30) dient, gemessen in der genannten ersten Richtung, wodurch die Hochpaßabschneidefrequenz für die Wellenleitermodusfortpflanzung durch den Behälter (30) in der genannen zweiten Richtung über die genannte vorbestimmte Signalfrequenz angehoben wird.

2. Vorrichtung nach Anspruch 1, bei der die zusätzliche Schaltung (17) innerhalb des Behälters (30) in dem genannten zusätzlichen Raum (16) montiert ist.

3. Vorrichtung nach Anspruch 1 oder 2, bei der der genannte elektrisch leitende Vorsprung (15/22) einstückig mit der ersten genannten Seitenwand (2b) ausgebildet ist und sich von dieser zu der genannten Schaltung (3) erstreckt.

4. Vorrichtung nach Anspruch 1 oder 2, bei der der genannte elektrisch leitende Vorsprung (20) separat von der genannten ersten Seitenwand (2b) ist.

5.  Vorrichtung nach einem der vorhergehenden Ansprüche, mit einer elektrischen Verbindungsleitung, die einen elektrischen Anschluß (21) umfaßt, der einen metallischen Film umfaßt, seitlich umgeben von elektrischer Isolation (11,12), der sich vollständig durch den genannten elektrischen leitenden Vorsprung (15/20/22) in der genannten zweiten Richtung erstreckt.

6.  Vorrichtung nach einem der vorhergehenden Ansprüche, so montiert, daß ihre genannte dritte Seitenwand sich längs der genannten vierten Seitenwand von einer weiteren solchen Vorrichtung erstreckt, und deren genannter Eingangsanschluß (13a) mit dem Ausgangsanschluß (13b) der genannten weiteren Vorrichtung verbunden ist.

7.  Vorrichtung nach einem der vorhergehenden Ansprüche bei dem der genannte Behälter ferner einen zweiten elektrisch leitenden Vorsprung (15/20/22) hat, der sich, von der genannten Abdeckung (19) zu der genannten inneren Basisoberfläche (1), zwischen der genannten zweiten Seitenwand (2b) und der genannten Schaltung (3) erstreckt, während ein ausreichender zusätzlicher Raum (16) in dem Behälter (30) zwischen der genannten Schaltung (3) und der genannten zweiten Seitenwand (2b) gelassen wird, um zusätzliche Schaltungselemente zu montieren oder zur Handhabung von Elementen der genannten Schaltung (3) während ihrer Montage.

# Fig. 1

Fig. 2A

Fig. 2B

Fig. 3A

Fig. 3B

Fig. 4A

Fig. 4B

Fig. 5A

Fig. 5B

Fig. 5C

# Fig. 6